Europäisches Patentamt

European Patent Office

Office européen des brevets

(19)

(11) Veröffentlichungsnummer: **0 170 767 B1**

(12) **EUROPÄISCHE PATENTSCHRIFT**

(45) Veröffentlichungstag der Patentschrift: 04.09.91

(51) Int. Cl.⁵: **H05K 1/05**, C03C 10/06

(21) Anmeldenummer: 85102866.2

(22) Anmeldetag: 13.03.85

(54) **Träger für gedruckte Schaltungen.**

(30) Priorität: 10.07.84 DE 3425260
20.07.84 DE 3426804

(43) Veröffentlichungstag der Anmeldung:
12.02.86 Patentblatt 86/07

(45) Bekanntmachung des Hinweises auf die
Patenterteilung:
04.09.91 Patentblatt 91/36

(84) Benannte Vertragsstaaten:
DE FR GB IT NL SE

(56) Entgegenhaltungen:
EP-A- 0 080 345
GB-A- 2 139 611

(73) Patentinhaber: W.C. Heraeus GmbH
Heraeusstrasse 12 - 14
W-6450 Hanau / Main(DE)

(72) Erfinder: Deckelmann, Karl, Dr. Dipl.-Chem.
Schlossgasse 5
W-8750 Aschaffenburg(DE)
Erfinder: Hornung, Jürgen
Im Steingarten 18
W-6466 Gründau 6(DE)
Erfinder: Jones, Graham Stewart
24 Cove RD
Fleet Hampshire(GB)
Erfinder: Kersting, Roland, Dr.
Vorm Stichel 30
W-6458 Rodenbach 1(DE)
Erfinder: Reynolds, Quentin, Dipl.-Phys.
13 Findlay Drive
Worplesdon Surrey, GU3 3HT(GB)
Erfinder: Taitl, Ino, Dipl.-Ing.
Kinzigstrasse 4
W-6467 Hasselroth 2(DE)

(74) Vertreter: Heinen, Gerhard, Dr.
Heraeusstrasse 12-14
W-6450 Hanau/Main(DE)

## Beschreibung

Die Erfindung betrifft ein Substrat für gedruckte Schaltungen aus Metall-Silicat-Schichtverbundwerkstoff.

Für die Herstellung von gedruckten Schaltungen durch Aufdrucken und Einbrennen von Leiter-, Widerstands- und Dielektrikumspasten werden meist Substrate aus Keramik, besonders Aluminiumoxid, oder aus emailliertem Stahl benutzt.

Obwohl Substrate aus emailliertem Stahl gegenüber solchen aus Keramik manche Vorteile besitzen, werden sie bisher nur für spezielle Zwecke eingesetzt. Ein wesentlicher Grund dafür ist die niedrige Erweichungstemperatur des Emails, die nur Einbrenntemperaturen unterhalb von etwa 650 °C erlaubt.

Es ist die Aufgabe der Erfindung, ein für die Herstellung gedruckter Schaltungen geeignetes Substrat zu finden, das die Vorteile eines Substrats aus emailliertem Stahl besitzt, jedoch eine noch bei Temperaturen oberhalb von etwa 650 °C, insbesondere oberhalb 830 °C, stabile Oberflächenschicht besitzt, so daß auch für Keramik-Substrate entwickelte Pasten darauf eingebrannt werden können.

Das die Lösung der Aufgabe darstellende Substrat aus Metall-Silicat-Schichtverbunduerkstoff ist erfindungsgemäß gekennzeichnet durch die Zusammensetzung wie in dem Anspruch 1 oder 2 definiert ist.

Unter "Metall", das zusammen mit der Glaskeramik das Substrat gemäß der Erfindung bildet, werden für diesen Zweck geeignete temperaturbeständige Metalle und Legierungen verstanden. Besonders bewährt haben sich Stähle, zum Beispiel Sicromal, Invar® und verkupfertes Invar®.

Die Substrate gemäß der Erfindung sind nicht nur bis 830 °C, sondern sogar bis etwa 980 °C stabil und können ohne nachteilige Veränderungen wiederholt auf Temperaturbereiche bis etwa 980 °C erhitzt werden.

Die Glaskeramik haftet fest auf dem Metall und löst sich auch beim Verbiegen des Substrats nicht ab. Diese Glaskeramik/Metall-Verbindung ist vibrationsstabil, d. h. sie ist unempfindlich gegen Erschütterungen und sonstige Biegebeanspruchungen, und eignet sich deshalb besonders gut in der Verwendung als Schaltkreissubstrat für den Einsatz in der KFZ-Elektronik. Im Gegensatz hierzu sind die bekannten Aluminiumoxid-Keramik-Substrate äußerst spröde und demzufolge anfällig gegen Erschütterungen. Die Dicke der Glaskeramik-Schicht soll mindestens 20 µm betragen; bevorzugt wird eine Dicke von 30 bis 60 µm.

Mit für Keramik-Substrate benutzten Druckpasten sind die Substrate gemäß der Erfindung verträglich; die eingebrannten Leiter- und Widerstandsbahnen besitzen reproduzierbare Leitfähigkeits- und Widerstandswerte. Mehrschicht-Schaltungen (multilayer) sind wie bei Keramik-Substraten möglich.

Da die Glaskeramik frei von Alkalimetallen ist, tritt keine Verunreinigung der Widerstandsbahnen und damit keine Änderung ihres Widerstands mit der Zeit ein.

Die Schichtverbund-Substrate gemäß der Erfindung werden durch Aufbringen eines rekristallisierenden Glases in der der Glaskeramik entsprechenden Zusammensetzung in Pulver- oder Pastenform oder als Suspension in geeigneter Weise auf das Metall und Einbrennen an Luft bei Temperaturen bis etwa 980 °C hergestellt. Dem Pulver, der Paste oder der Suspension kann ein organischer oder anorganischer Farbstoff, zum Beispiel Kobaltsilicat, zugesetzt werden.

Das Aufbringen des Pulvers kann zum Beispiel durch Flamm- oder Plasmaspritzen erfolgen. Soll das Glas in Pastenform aufgebracht werden, so wird das Glaspulver mit einem geeigneten organischen Träger, zum Beispiel Terpineol/Äthylcellulose, gemischt und die erhaltene pastenförmige Mischung durch zum Beispiel elektrostatisches Sprühen, Drucken, Tauchen, Pinseln oder Spritzen auf das Metall aufgebracht.

Besonders bewährt hat sich das gegebenenfalls zu wiederholende Aufbringen durch Siebdruck. Dadurch ist es möglich, auf einfache Weise sowohl die gesamte Metalloberfläche als auch nur bestimmte Teilbereiche der Metalloberfläche mit der Glaskeramik zu versehen. Grundsätzlich ist das erfindungsgemäße Substrat in großen Formaten preisgünstig zu erstellen.

Die mit einem oder mehreren Glaskeramik-Teilbereichen versehenen Substrate stellen eine besonders vorteilhafte Ausbildung der Erfindung dar. Sie bieten zum Beispiel die Möglichkeit, das Substrat als Träger für die gedruckte Schaltung und gleichzeitig als Konstruktionselement, zum Beispiel als ein in der Mitte mit der Glaskeramik und darauf aufgebrachter gedruckter Schaltung versehener Deckel eines Gehäuses, zu benutzen.

Die mit dem Substrat gemäß der Erfindung in Dickschicht-Technik hergestellten gedruckten Schaltungen können auch als Heizleiter Verwendung finden.

Zur näheren Erläuterung wird in den folgenden Beispielen die Herstellung eines Metall-Silicat-Substrats gemäß der Erfindung, die Herstellung von Leiter- und Widerstandsbahnen unter Verwendung von für Keramik-Substrate üblichen Leiter-und Widerstandspasten beschrieben und der erzielte Flächenwiderstand mit dem von auf Aluminiumoxid erzeugten Widerstandsbahnen verglichen.

Beispiel 1

Herstellung eines Metall-Silicat-Substrats gemäß der Erfindung Ein 15 x 10 cm (etwa DIN A 6-Format) großes Stahl-Blech (Werkstoff-Nr. 1.4742) wird durch Sandstrahlen oberflächenbehandelt. Dann wird eine Paste aus 70 % pulverförmigem Glas aus 35,2 Gewichts-% BaO, 10,3 Gewichts-% $Al_2O_3$ und 54,5 Gewichts-% $SiO_2$ und 30 Gewichts-% einer Mischung aus 92 Gewichts-% Terpineol und 8 Gewichts-% Äthylcellulose durch Siebdruck auf das Stahl-Blech aufgebracht, 10 Minuten bei 150 °C getrocknet und im Durchlaufofen 60 Minuten lang, wobei 10 Minuten lang eine Spitzen-Temperatur von 950 °C herrscht, eingebrannt.

Beispiel 2

Bestimmung des Widerstandes von Widerstandsbahnen
a) auf dem Metall-Silicat-Substrat nach Beispiel 1
Auf das Metall-Silicat-Substrat wird eine für Aluminium-Keramik benutzte Ag/Pd-Leiterpaste (Heraprint C 4140, Ag : Pd-Verhältnis 26 : 1) im Siebdruck aufgebracht, getrocknet und 60 Minuten lang im Durchlaufofen bei maximal 850 ° (10 Minuten) eingebrannt. Dann wird eine ebenfalls für Aluminiumoxid-Keramik benutzte Ru-Oxid-Widerstandspaste (Heraprint R 40208) aufgedruckt und - wie für die Leiterpaste beschrieben - eingebrannt.
Der nach DIN 48 450 bestimmte Flächenwiderstand beträgt 95 $\Omega/\square$.
b) auf Aluminiumoxid
Auf ein 5 x 5 cm großes Aluminiumoxid-Plättchen werden - wie unter a) beschrieben - die Ag/Pd-Leiterpaste und die Ru-Oxid-Widerstandspaste aufgedruckt und eingebrannt.
Der nach DIN 48 450 bestimmte Flächenwiderstand beträgt 100 $\Omega/\square$.
Als Silicat für das aus einem Metall-Silicat-Schichtverbundwerkstoff bestehende Substrat gemäß der Erfindung hat sich neben der Glaskeramik aus 25 bis 40 Gewichts-% BaO, 5 bis 20 Gewichts-% $Al_2O_3$ und 40 bis 65 Gewichts-% $SiO_2$ eine Glaskeramik aus 25 bis 50 Gewichts-% BaO, 5 bis 20 Gewichts-% $Al_2O_3$, 30 bis 65 Gewichts-% $SiO_2$, 0 bis 15 Gewichts-% MgO, 0 bis 15 Gewichts-% CaO, 0 bis 5 Gewichts-% SrO, 0 bis 2 Gewichts-% $B_2O_3$, 0 bis 4 PbO, 0 bis 3 Gewichts-% ZnO und 0 bis 4 Gewichts-% $TiO_2$ besonders bewährt.

**Patentansprüche**

1. Substrat für gedruckte Schaltungen aus Metall-Silicat-Schichtverbundwerkstoff, dadurch gekennzeichnet, daß das Silicat eine Glaskeramik aus 25 bis 40 Gewichts-% BaO, 5 bis 20 Gewichts-% $Al_2O_3$ und 40 bis 65 Gewichts-%

$SiO_2$ ist.

2. Substrat für gedruckte Schaltungen aus Metall-Silicat-Schichtverbundwerkstoff; dadurch gekennzeichnet, daß das Silicat eine Glaskeramik aus 25 bis 50 Gewichts-% BaO, 5 bis 20 Gewichts-% $Al_2O_3$, 30 bis 65 Gewichts-% $SiO_2$, 0 bis 15 Gewichts-% MgO, 0 bis 15 Gewichts-% CaO, 0 bis 5 Gewichts-% SrO, 0 bis 2 Gewichts-% $B_2O_3$, 0 bis 4 Gewichts-% PbO, 0 bis 3 Gewichts-% ZnO und 0 bis 4 Gewichts-% $TiO_2$ ist.

3. Substrat nach Anspruch 1, dadurch gekennzeichnet, daß die Glaskeramik aus etwa 35 Gewichts-% BaO, 10 Gewichts-% $Al_2O_3$ und 55 Gewichts-% $SiO_2$ besteht.

4. Substrat nach einem der vorhergehenden Ansprüche, dadurch gekennzeichnet, daß die Glaskeramik zusätzlich einen anorganischen Farbstoff enthält.

5. Substrat nach einem der vorhergehenden Ansprüche, dadurch gekennzeichnet, daß das Metall Stahl ist.

6. Substrat nach einem der vorhergehenden Ansprüche, dadurch gekennzeichnet, daß es ein oder mehrere Glaskeramik-Teilbereiche aufweist.

7. Verwendung des Substrates nach einem der Ansprüche 1 bis 6 zur Herstellung einer gedruckten Schaltung in Dickschicht-Technik.

8. Verwendung des Substrates nach einem der Ansprüche 1 bis 6 zur Herstellung von Heizleitern in Dickschicht-Technik.

**Claims**

1. A substrate for printed circuits of composite laminated metal-silicate material, characterised in that the silicate is a vitreous ceramic comprising 25 to 40 weight % of BaO, 5 to 20 weight % of $Al_2O_3$ and 40 to 65 weight % of $SiO_2$.

2. A substrate for printed circuits of composite laminated metal-silicate material, characterised in that the silicate is a vitreous ceramic comprising 25 to 50 weight % of BaO, 5 to 20 weight % of $Al_2O_3$, 30 to 65 weight % of $SiO_2$, 0 to 15 weight % of MgO, 0 to 15 weight % of CaO, 0 to 5 weight % of SrO, 0 to 2 weight % of $B_2O_3$, 0 to 4 weight % of PbO, 0 to 3 weight % of ZnO and 0 to 4 weight % of $TiO_2$.

3. A substrate according to claim 1, characterised in that the vitreous ceramic comprises approximately 35 weight % of BaO, 10 weight % of $Al_2O_3$ and 55 weight % of $SiO_2$.

4. A substrate according to one of the preceding claims, characterised in that the vitreous ceramic additionally contains an inorganic pigment.

5. A substrate according to one of the preceding claims, characterised in that the metal is steel.

6. A substrate according to one of the preceding claims, characterised in that it has one or more vitreous ceramic part-regions.

7. Use of the substrate according to one of claims 1 to 6 for the production of a printed circuit by a thick layer technique.

8. Use of the substrate according to one of claims 1 to 6 for the production of heating conductors by a thick layer technique.

**Revendications**

1. Substrat pour circuits imprimes en matériau composite stratifié métal-silicate, caractérisé en ce que le silicate est une vitrocéramique consistant en 25 à 40 % en poids de BaO, 5 à 20 % en poids de $Al_2O_3$ et 40 à 65 % en poids de $SiO_2$.

2. Substrat pour circuits imprimés en matériau composite stratifié métal-silicate, caractérisé en ce que le silicate est une vitrocéramique consistant en 25 à 50 % en poids de BaO, 5 à 20 % en poids de $Al_2O_3$, 30 à 65 % en poids de $SiO_2$, 0 à 15 % en poids de MgO, 0 à 15 % en poids de CaO, 0 à 5 % en poids de SrO, 0 à 2 % en poids de $B_2O_3$, 0 à 4 % en poids de PbO, 0 à 3 % en poids de ZnO et 0 à 4 % en poids de $TiO_2$.

3. Substrat selon la revendication 1, caractérisé en ce que la vitrocéramique consiste en environ 35 % en poids de BaO, 10 % en poids de $Al_2O_3$ et 55 % en poids de $SiO_2$.

4. Substrat selon l'une des revendications précédentes, caractérisé en ce que la vitrocéramique contient en outre un colorant inorganique.

5. Substrat selon l'une des revendications précédentes, caractérisé en ce que le métal est de l'acier.

6. Substrat selon l'une des revendications précédentes, caractérisé en ce qu'il comporte un ou plusieurs domaines partiels de vitrocéramique.

7. Utilisation du substrat selon l'une des revendications 1 à 6 pour la fabrication d'un circuit imprimé dans la technique des couches épaisses.

8. Utilisation du substrat selon l'une des revendications 1 à 6 pour la fabrication de conducteurs chauffants dans la technique des couches épaisses.